# EUROPÄISCHE PATENTANMELDUNG

(11) **EP 4 613 412 A1**
(43) Veröffentlichungstag der Anmeldung: **10.09.2025**
(21) Anmeldenummer: 24162120.0
(22) Anmeldetag: 07.03.2024
(51) Int. Cl.: B23K 1/008

(54) **WIEDERAUFSCHMELZLÖTANLAGE ZUM DURCHFÜHREN EINES LÖTPROZESSES FÜR ZUMINDEST EIN BAUTEIL, SOWIE VERFAHREN ZUM BETREIBEN EINER WIEDERAUFSCHMELZLÖTANLAGE**

(71) Anmelder: Siemens Aktiengesellschaft, 80333 München (DE)
(72) Erfinder: Jeske, Nora, 10555 Berlin (DE); Müller, Bernd, 16259 Falkenberg (DE); Raab, Oliver, 94496 Ortenburg (DE); Sommerfeld, Dennis, 12347 Berlin (DE); Wittreich, Ulrich, 16727 Velten (DE)
(74) Vertreter: Siemens Patent Attorneys

(57) **Zusammenfassung**

Die Erfindung betrifft eine Wiederaufschmelzlötanlage (10) zum Durchführen eines Lötprozesses für zumindest ein Bauteil (26, 28, 30), mit zumindest einem ersten Transportband (18) zum Transportieren des Bauteils (26, 28, 30) durch die Wideraufschmelzlötanlage (10) während des Lötprozesses, und mit einer elektronischen Recheneinrichtung (12) zum Steuern des ersten Transportbandes (18), wobei die Wiederaufschmelzlötanlage (10) zumindest ein zweites Transportband (20) aufweist, welches in einer Transportrichtung (32) der Wiederaufschmelzlötanlage (10) für das Bauteil (26, 28, 30) an das erste Transportband (18) angegliedert ist, wobei die elektronische Recheneinrichtung (12) dazu ausgebildet ist, unabhängig vom ersten Transportband (18) das zweite Transportband (20) zu steuern. Ferner betrifft die Erfindung ein Verfahren.

## Beschreibung

Die Erfindung betrifft eine Wiederaufschmelzlötanlage zum Durchführen eines Lötprozesses für zumindest ein Bauteil, mit zumindest einem ersten Transportband zum Transportieren des Bauteils durch die Wiederaufschmelzlötanlage während des Lötprozesses, und mit einer elektronischen Recheneinrichtung zum Steuern des ersten Transportbandes gemäß dem geltenden Patentanspruch 1. Ferner betrifft die Erfindung ein Verfahren zum Betreiben einer Wiederaufschmelzlötanlage.

Insbesondere bei Elektronikfertigungen werden die Prozessräume häufig nur zu einem gewissen Anteil innerhalb einer Wiederaufschmelzlötanlage, welche auch als Reflow-Anlage bezeichnet wird, genutzt. So ergeben sich unter anderem bei Produkt- beziehungsweise Programmwechsel Stillstandszeiten, da diese in der Regel mit Temperaturanpassungen beziehungsweise Transportbreitenverstellungen verbunden sind. Bevor ein neues Produkt gefertigt werden kann, muss zunächst der Prozessraum leerlaufen und die durch den Programmwechsel notwendige Umstellung erfolgen. Erst wenn die geforderten Toleranzen, insbesondere Temperaturen, in den jeweiligen Zonen, die Transportbreite beziehungsweise die Position der Mittenunterstützung, eingehalten werden, wird der Einlauf für die Produktion freigegeben.

Bezüglich der effektiveren Nutzung von Prozessräumen werden im Stand der Technik bereits heute mehrspurige Transportsysteme in den Reflow-Lötanlagen angeboten. Diese haben einen deutlich erhöhten Durchsatz, aber eingeschränkte Flexibilität.

Aufgabe der vorliegenden Erfindung ist es, eine Wiederaufschmelzlötanlage sowie ein Verfahren zu schaffen, mittels welchen verbessert ein Lötprozess für zumindest ein Bauteil realisiert werden kann.

Diese Aufgabe wird durch eine Wiederaufschmelzlötanlage sowie durch ein Verfahren gemäß den unabhängigen Patentansprüchen gelöst. Vorteilhafte Ausgestaltungsformen sind in den Unteransprüchen angegeben.

Ein Aspekt der Erfindung betrifft eine Wiederaufschmelzlötanlage zum Durchführen eines Lötprozesses für zumindest ein Bauteil, mit zumindest einem ersten Transportband zum Transportieren des Bauteils durch die Wiederaufschmelzlötanlage während des Lötprozesses, und mit einer elektronischen Recheneinrichtung zum Steuern des ersten Transportbandes.

Es ist dabei vorgesehen, dass die Wiederaufschmelzlötanlage zumindest ein zweites Transportband aufweist, welches in einer Transportrichtung der Wiederaufschmelzlötanlage für das Bauteil an das erste Transportband angegliedert ist, wobei die elektronische Recheneinrichtung dazu ausgebildet ist, unabhängig vom ersten Transportband das zweite Transportband zu steuern.

Insbesondere kann somit eine intelligente, zonenweise Segmentierung innerhalb der Wiederaufschmelzlötanlage über die unterschiedlichen Transportbänder bereitgestellt werden. Die Lösung reduziert insbesondere die Stillstandszeiten durch eine intelligente Steuerung.

Insbesondere sind somit Energieeinsparungen möglich, indem die Prozessräume intelligenter genutzt werden. Die Reduzierung von Stillstandszeiten und die Erhöhung der Flexibilität kann durch die zonenweise Segmentierung der Wiederaufschmelzlötanlage auf Basis der zumindest zwei aufeinanderfolgenden Transportbänder erreicht werden. Damit wird ein hochflexibler Betrieb der Wiederaufschmelzlötanlage ermöglicht, da sich die maximalen Stillstandszeiten auf beispielsweise eine entsprechende Zonenlänge beschränken.

Insbesondere kann somit die Flexibilität in der Nutzung sowie die Energie- und Ressourceneffizienz signifikant gesteigert werden. Die Stillstandszeiten durch Produktumstellungen werden reduziert, ferner wird ein flexibler Mixbetrieb, beispielsweise mit unterschiedlichen Produkten zur gleichen Zeit innerhalb der Wiederaufschmelzlötanlage, welche auch als Reflow-Anlage bezeichnet werden kann, bereitgestellt. Ein weiterer Vorteil ist, dass durch den insgesamt erhöhten Durchsatz, und somit geringen Rüstzeiten, eine höhere Produktivität der Anlage und damit insbesondere auch eine Kostenersparnis realisiert werden kann.

Gemäß einer vorteilhaften Ausgestaltungsform ist die elektronische Recheneinrichtung zum Einstellen unterschiedlicher Transportgeschwindigkeiten der zumindest zwei Transportbänder ausgebildet. Beispielsweise kann das erste Transportband mit einer ersten Transportgeschwindigkeit und das zweite Transportband mit einer zur ersten Transportgeschwindigkeit unterschiedlichen zweiten Transportgeschwindigkeit bereitgestellt werden. Ferner ist es auch möglich, dass beispielsweise gleiche Transportgeschwindigkeiten bereitgestellt werden. Insbesondere kann eine Anpassung, je nachdem welches Bauteil sich gerade auf den Transportbändern befindet, entsprechend angepasst werden. Somit kann hochflexibel die Wiederaufschmelzlötanlage betrieben werden.

Eine weitere vorteilhafte Ausgestaltungsform sieht vor, dass zumindest das erste Transportband und/oder das zweite Transportband eine seitliche Begrenzung für das Bauteil aufweisen, wobei die seitliche Begrenzung für eine Einstellung einer Breite variabel verschiebbar ist. Insbesondere kann die seitliche Begrenzung auch als so genannte variable Wange bezeichnet werden. Somit können Bauteile unterschiedlicher Breite durch die Wiederaufschmelzlötanlage eingebracht werden. Die elektronische Recheneinrichtung kann dann, je nachdem welches Bauteil sich innerhalb der Wiederaufschmelzlötanlage befindet, beziehungsweise welches Bauteil sich auf dem jeweiligen Transportband befindet, die Breite entsprechend einstellen. Die Wiederaufschmelzlötanlage weist ferner bevorzugt eine feste Wange auf. Somit kann hochflexibel die Wiederaufschmelzlötanlage betrieben werden, da insbesondere unterschiedliche Bauteile innerhalb der Wiederaufschmelzlötanlage im Wesentlichen zur gleichen Zeit entsprechend gelötet werden können.

Weiterhin vorteilhaft ist, wenn einem jeweiligen Transportband eine jeweilige Heizeinrichtung zugeordnet ist. Somit weist insbesondere jedes Transportband eine eigene zugeordnete Heizeinrichtung auf. Die Heizeinrichtung ist insbesondere dazu ausgebildet, entsprechende Temperaturen zu erzeugen, um den Lötprozess beziehungsweise Lötvorgang an dem Bauteil durchzuführen. Insbesondere kann dabei vorgesehen sein, dass lediglich ein Vorheizen für das Löten beziehungsweise vorgegebener Abkühlprozess für das Löten bereitgestellt wird. Die entsprechenden Temperaturen können von der elektronischen Recheneinrichtung eingestellt werden.

Eine weitere vorteilhafte Ausgestaltungsform sieht vor, dass die elektronische Recheneinrichtung dazu ausgebildet ist, die jeweiligen Heizeinrichtungen unabhängig voneinander zu steuern. Insbesondere können die Heizeinrichtungen somit unterschiedliche Temperaturen aufweisen. Somit kann je nachdem, beispielsweise welche Geschwindigkeit am Transportband eingestellt ist, die Heizeinrichtung zusätzlich mitgesteuert werden. Insbesondere können entsprechende Temperaturen der Heizeinrichtung beispielsweise gesteuert werden. Somit kann hochflexibel die Wiederaufschmelzlötanlage betrieben werden.

Es hat sich weiterhin als vorteilhaft erwiesen, wenn die Heizeinrichtungen als Lüftereinrichtungen ausgebildet sind. Insbesondere können die entsprechenden Lüftereinrichtungen beispielsweise im Wesentlichen aus Rotationslüftern bestehen. Die Rotationslüfter können dann entsprechend vorgeheizte Luft, beispielsweise auf Basis eines elektrischen Heizverfahrens, an das Bauteil übergeben. Somit kann zuverlässig ein Lötprozess innerhalb der Wiederaufschmelzlötanlage realisiert werden.

Ferner hat es sich als vorteilhaft erwiesen, wenn eine jeweilige Heizeinrichtung zumindest zwei Lüftereinrichtungen aufweist. Dadurch wird ermöglicht, dass zuverlässig und prozesssicher ein Lötvorgang innerhalb der Wiederaufschmelzlötanlage realisiert werden kann.

Es hat sich weiterhin als vorteilhaft erwiesen, wenn die elektronische Recheneinrichtung dazu ausgebildet ist, eine Temperatur der jeweiligen Heizeinrichtung und/oder eine Drehgeschwindigkeit der jeweiligen Heizeinrichtung zu steuern. Insbesondere kann somit sowohl auf Basis der Temperatur als auch auf Basis eines Luftflusses eine Steuerung des Lötprozesses realisiert werden. Die elektronische Recheneinrichtung kann somit mit unterschiedlichen Möglichkeiten die Heizeinrichtung steuern. Je nachdem, welches Bauteil sich gerade innerhalb der Wiederaufschmelzlötanlage befindet, kann somit zuverlässig ein Lötprozess realisiert werden. Beispielsweise kann auf Basis von Angaben eines Herstellers für die entsprechenden Bauteile eine Drehgeschwindigkeit beziehungsweise Temperatur eingestellt werden. Somit kann ein zuverlässiger Lötprozess bereitgestellt werden.

Ferner hat es sich als vorteilhaft erwiesen, wenn die Wiederaufschmelzlötanlage zumindest ein drittes Transportband aufweist, welches an das zweite Transportband angegliedert ist, wobei die elektronische Recheneinrichtung dazu ausgebildet ist, das dritte Transportband unabhängig vom ersten Transportband und vom zweiten Transportband zu steuern. Insbesondere ist die Wiederaufschmelzlötanlage nicht auf drei Transportbänder, welche insbesondere hintereinandergeschaltet sind, beschränkt. Es ist auch möglich, dass die Wiederaufschmelzlötanlage mehr als drei Transportbänder hintereinander, insbesondere in Reihe geschaltet, aufweist. Somit kann bauteilspezifisch die Wiederaufschmelzlötanlage bereitgestellt werden. Des Weiteren kann durch die unabhängige Steuerung der Transportbänder ein zuverlässiger Lötprozess bereitgestellt werden. Insbesondere ist die Wiederaufschmelzlötanlage auf Basis der Vielzahl an Transportbändern hochflexibel einsetzbar, so dass Rüstzeiten und Stillstandszeiten der Wiederaufschmelzlötanlage reduziert werden können.

Eine weitere vorteilhafte Ausgestaltungsform sieht vor, dass dem dritten Transportband eine dritte Heizeinrichtung zugeordnet ist. Dabei kann ferner vorgesehen sein, dass die dritte Heizeinrichtung ebenfalls als Lüftereinrichtung ausgebildet ist. Es kann ferner vorgesehen sein, dass eine entsprechende Temperatur und Drehgeschwindigkeit der dritten Heizeinrichtung angesteuert werden können. Somit kann prozesssicher und hochflexibel die Wiederaufschmelzlötanlage betrieben werden.

Ebenfalls vorteilhaft ist, wenn die elektronische Recheneinrichtung dazu ausgebildet ist, unabhängig von einer ersten Heizeinrichtung für das erste Transportband und einer zweiten Heizeinrichtung für das zweite Transportband die dritte Heizeinrichtung zu steuern. Somit kann hochflexibel auch die dritte Heizeinrichtung unabhängig von der ersten Heizeinrichtung und der zweiten Heizeinrichtung betrieben werden. Dadurch kann ein verbesserter Lötprozess realisiert werden. Des Weiteren kann hochflexibel und bauteilspezifisch der Lötvorgang durchgeführt werden.

In einer weiteren vorteilhaften Ausgestaltungsform ist vorgesehen, dass die Wiederaufschmelzlötanlage eine erste Transportspur mit zumindest dem ersten Transportband und dem zweiten Transportband aufweist und eine zweite Transportspur mit zumindest einem weiteren Transportband aufweist. Insbesondere können die erste Transportspur und die zweite Transportspur dabei im Wesentlichen parallel zueinander verlaufen. Dabei kann auch die zweite Transportspur eine Vielzahl von entsprechenden Transportbändern aufweisen. Insbesondere ist die Anzahl der Transportbänder in der ersten Transportspur unabhängig von der Anzahl der Transportbänder in der zweiten Transportspur. Somit kann mittels einer einzigen Wiederaufschmelzlötanlage eine Vielzahl von unterschiedlichen Bauteilen, insbesondere auch parallel zueinander, gelötet werden. Es sind selbstverständlich auch mehr als zwei Transportspuren möglich. Somit kann ein vorteilhafter Lötprozess für eine Vielzahl von unterschiedlichen Bauteilen spezifisch realisiert werden.

Ein weiterer Aspekt der Erfindung betrifft ein Verfahren zum Betreiben einer Wiederaufschmelzlötanlage nach dem vorhergehenden Aspekt. Es erfolgt das Transportieren des zumindest einen Bauteils mittels des ersten Transportbands. Es wird das Bauteil von dem ersten Transportband zu dem zweiten Transportband übergeben. Es erfolgt das Transportieren des zumindest einen Bauteils mittels des zweiten Transportbandes und ein separates Steuern des ersten Transportbandes und des zweiten Transportbandes mittels der elektronischen Recheneinrichtung.

Insbesondere wird während des oben beschriebenen Verfahrens der Lötprozess durchgeführt.

Somit kann hochflexibel auf Basis der Segmentierung des Transportbandes ein zuverlässiger Lötprozess realisiert werden, welcher insbesondere zur Reduzierung von Stillstandszeiten beiträgt.

Gemäß einer vorteilhaften Ausgestaltungsform des Verfahrens wird das erste Transportband mit einer unterschiedlichen Geschwindigkeit betrieben als das zweite Transportband. Es kann alternativ auch vorgesehen sein, dass das erste Transportband und das zweite Transportband mit der gleichen Geschwindigkeit betrieben werden. Insbesondere kann die elektronische Recheneinrichtung die entsprechende Geschwindigkeit des ersten Transportbands und des zweiten Transportbands steuern. Bauteilspezifisch kann die Geschwindigkeit entsprechend eingestellt werden. Somit kann hochflexibel die Wiederaufschmelzlötanlage betrieben werden.

Es hat sich weiterhin als vorteilhaft erwiesen, wenn eine Heizeinrichtung, welche dem ersten Transportband zugeordnet ist, unterschiedlich betrieben wird als eine zweite Heizeinrichtung, welche dem zweiten Transportband zugeordnet ist. Beispielsweise kann die erste Heizeinrichtung mit einer ersten Temperatur und/oder einer ersten Drehgeschwindigkeit einer Lüftereinrichtung betrieben werden. Die zweite Heizeinrichtung kann mit einer unterschiedlichen Temperatur und mit einer unterschiedlichen Drehgeschwindigkeit betrieben werden als die erste Heizeinrichtung. Somit kann bauteilspezifisch und hochflexibel der Betrieb der Wiederaufschmelzlötanlage realisiert werden.

Vorteilhafte Ausgestaltungsformen der Wiederaufschmelzlötanlage sind als vorteilhafte Ausgestaltungsformen des Verfahrens anzusehen. Die Wiederaufschmelzlötanlage weist hierzu gegenständliche Merkmale auf, um entsprechende Verfahrensschritte durchführen zu können.

Bei dem vorgestellten Verfahren handelt es sich zumindest teilweise um ein computerimplementiertes Verfahren. Daher betrifft ein weiterer Aspekt der Erfindung auch ein Computerprogrammprodukt mit Programmcodemitteln, welche die elektronische Recheneinrichtung dazu veranlassen, wenn die Programmcodemittel von der elektronischen Recheneinrichtung abgearbeitet werden, ein Verfahren zumindest in Teilen entsprechend durchführen zu können. Ein nochmals weiterer Aspekt der Erfindung betrifft daher auch ein computerlesbares Speichermedium mit dem Computerprogrammprodukt.

Unter einer Recheneinheit/elektronischer Recheneinrichtung kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Dabei zeigen:
- FIG 1: eine schematische Draufsicht auf eine Ausführungsform einer Wiederaufschmelzlötanlage; und
- FIG 2: eine schematische Seitenansicht einer Ausführungsform einer Wiederaufschmelzlötanlage.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

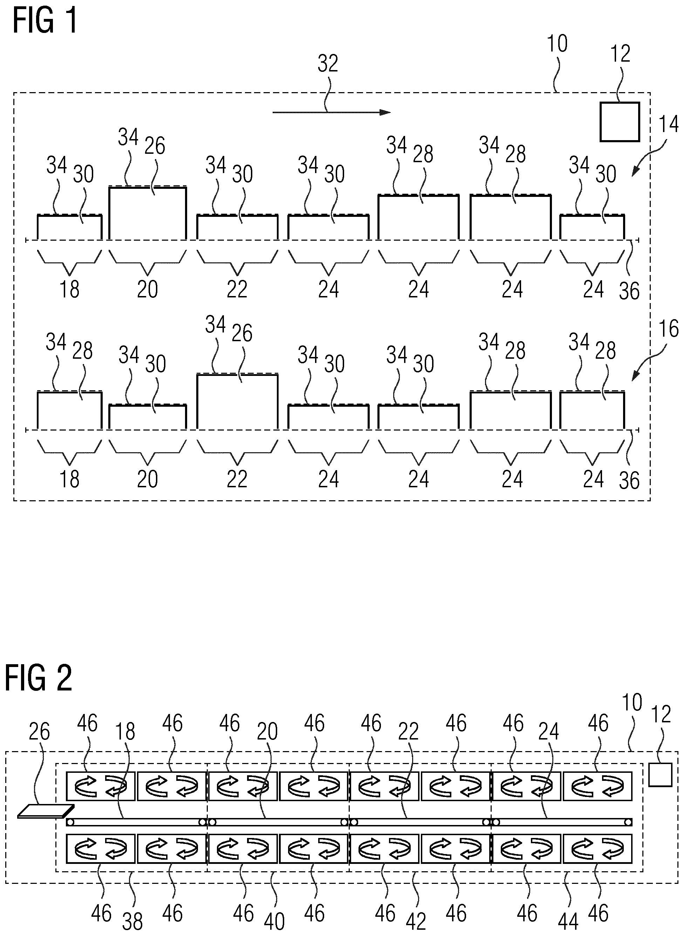

FIG 1 zeigt eine schematische Seitenansicht einer Ausführungsform einer Wiederaufschmelzlötanlage 10. Die Wiederaufschmelzlötanlage 10 weist im folgenden Ausführungsbeispiel zumindest eine elektronische Recheneinrichtung 12 auf. Ferner ist gezeigt, dass die vorliegende Wiederaufschmelzlötanlage 10 eine erste Transportspur 14 sowie eine zweite Transportspur 16 aufweist.

Nachfolgend wird insbesondere die erfindungsgemäße Lösung anhand der ersten Transportspur 14 näher erläutert. Es gelten die entsprechenden Ausführungsformen jedoch auch für die zweite Transportspur 16.

Die FIG 1 zeigt vorliegend insbesondere, dass die erste Transportspur 14 ein erstes Transportband 18 sowie zumindest ein zweites Transportband 20 aufweisen kann. Ferner ist vorliegend zumindest ein drittes Transportband 22 gezeigt. Die FIG 1 zeigt ferner, dass die erste Transportspur 14 weitere Transportbänder 24 aufweisen kann, welche insbesondere im Wesentlichen in Reihe zueinander geschaltet sind.

Insbesondere zeigt somit die FIG 1, dass zumindest ein Bauteil 26, 28, 30 für einen Lötprozess über die entsprechenden Transportbänder 18, 20, 22, 24 innerhalb der ersten Transportspur 14 verbracht wird.

Dabei weist die Wiederaufschmelzlötanlage 10 zumindest das erste Transportband 18 zum Transportieren des Bauteils 26, 28, 30 während des Lötprozesses auf sowie die elektronische Recheneinrichtung 12. Es ist nun vorgesehen, dass die Wiederaufschmelzlötanlage 10 zumindest das zweite Transportband 20 aufweist, welches in einer Transportrichtung 32 der Wiederaufschmelzlötanlage 10 für das Bauteil 26, 28, 30 an das erste Transportband 18 angegliedert ist, wobei die elektronische Recheneinrichtung 12 dazu ausgebildet ist, unabhängig vom ersten Transportband 18 das zweite Transportband 20 zu steuern.

Dabei zeigt die FIG 1 insbesondere, dass beispielsweise drei unterschiedliche Bauteile 26, 28, 30 innerhalb der ersten Transportspur 14 zu verzeichnen sind. Insbesondere kann somit ein Lötprozess für die drei Bauteile 26, 28, 30 im Wesentlichen zeitgleich durchgeführt werden. Dabei sind insbesondere ein erstes Bauteil 26, ein zweites Bauteil 28 sowie ein drittes Bauteil 30 gezeigt.

Dabei kann insbesondere vorgesehen sein, dass die elektronische Recheneinrichtung 12 zum Einstellen unterschiedlicher Transportgeschwindigkeiten der zumindest zwei Transportbänder 18, 20, 22, 24 ausgebildet ist. Ferner kann dabei vorgesehen sein, dass zumindest das erste Transportband 18 und/oder das zweite Transportband 20 eine seitliche Begrenzung 34 für das Bauteil 26, 28, 30 aufweisen kann, wobei die seitliche Begrenzung 34 für eine Einstellung einer Breite variabel verschiebbar ist. Ferner zeigt die FIG 1 auch eine feste Begrenzung 36, welche insbesondere nicht verschiebbar ist.

Die FIG 1 zeigt ferner, dass die Wiederaufschmelzlötanlage 10 zumindest ein drittes Transportband aufweist, welches an das zweite Transportband 20 angegliedert ist, wobei die elektronische Recheneinrichtung 12 dazu ausgebildet ist, das dritte Transportband 22 unabhängig vom ersten Transportband 18 und vom zweiten Transportband 20 zu steuern.

Insbesondere zeigt somit die FIG 1, dass Energieeinsparungen möglich sind, indem die Prozessräume intelligenter genutzt werden. Dabei können insbesondere mehrere parallele Transportspuren 14, 16, wie bereits bekannt, angeboten werden. Die Reduzierung von Stillstandszeiten und die Erhöhung der Flexibilität kann durch die zonenweise Segmentierung über die Mehrzahl an separat betreibbaren Transportbändern 18, 20, 22, 24 erreicht werden. Ergänzt wird dies durch die variable Breite des einstellbaren Transportsystems je Zone und Transportspur 14, 16 sowie der modularen Regelung beispielsweise der Geschwindigkeiten der Transportbänder 18, 20, 22, 24.

FIG 2 zeigt eine schematische Seitenansicht einer Ausführungsform der Wiederaufschmelzlötanlage 10. Im folgenden Ausführungsbeispiel ist insbesondere gezeigt, dass einem jeweiligen Transportband 18, 20, 22, 24 eine jeweilige Heizeinrichtung 38, 40, 42, 44 zugeordnet ist. Insbesondere ist im folgenden Ausführungsbeispiel dem ersten Transportband 18 eine erste Heizeinrichtung 38 zugeordnet. Dem zweiten Transportband 20 ist eine zweite Heizeinrichtung 40 zugeordnet. Dem dritten Transportband 22 ist eine dritte Heizeinrichtung 42 zugeordnet und dem weiteren Transportband 24 ist eine weitere Heizeinrichtung 44 zugeordnet. Dabei kann insbesondere vorgesehen sein, dass die elektronische Recheneinrichtung 12 dazu ausgebildet ist, die jeweiligen Heizeinrichtungen 38, 40, 42, 44 unabhängig und insbesondere separat zueinander zu steuern. Dabei zeigt die FIG 2 ferner, dass die Heizeinrichtungen 38, 40, 42, 44 als Lüftereinrichtungen 46 ausgebildet sind. Dabei kann eine jeweilige Heizeinrichtung 38, 40, 42, 44 zumindest zwei Lüftereinrichtungen 46 aufweisen. Vorliegend sind insbesondere jeweils vier Lüftereinrichtungen 46 einer jeweiligen Heizeinrichtung 38, 40, 42, 44 zugeordnet.

Insbesondere zeigt die FIG 2, dass vorliegend oberhalb der Transportbänder 18, 20, 22, 24 jeweils zwei Lüftereinrichtungen 46 ausgebildet sind und unterhalb der Transportbänder 18, 20, 22, 24 jeweils zwei Lüftereinrichtungen 46 zugewiesen sind. Dabei kann ferner vorgesehen sein, dass die elektronische Recheneinrichtung 12 dazu ausgebildet ist, eine Temperatur der jeweiligen Heizeinrichtung 38, 40, 42, 44 und/oder die Drehgeschwindigkeit, insbesondere der Lüftereinrichtungen 46, der jeweiligen Heizeinrichtung 38, 40, 42, 44 zu steuern. Insbesondere ist somit gezeigt, dass sich durch die variable Breiteneinstellungen je Zone und Spur eine modulare Regelung der Lüfterfrequenzen und der Zonen realisieren lässt. Damit wird ein hochflexibler Betrieb der Wiederaufschmelzlötanlage 10 möglich, da sich die maximalen Stillstandszeiten auf die Zonenlänge beschränken. Ferner können individuell sowohl Transportgeschwindigkeit und Lüfterfrequenz je Zone auf ein Minimum abgesenkt werden, wenn diese nicht benötigt werden, beispielsweise größerer Abstand zwischen den Bauteilen 26, 28, 30, Umrüstzeiten in der Linie oder dergleichen. Dies wiederum führt zu weiteren Energiesparpotentialen beispielsweise für Gas und Strom.

### Bezugszeichenliste

- 10: Wiederaufschmelzlötanlage
- 12: elektronische Recheneinrichtung
- 14: erste Transportspur
- 16: zweite Transportspur
- 18: erstes Transportband
- 20: zweites Transportband
- 22: drittes Transportband
- 24: weiteres Transportband
- 26: erstes Bauteil
- 28: zweites Bauteil
- 30: drittes Bauteil
- 32: Transportrichtung
- 34: Begrenzung
- 36: Begrenzung
- 38: erste Heizeinrichtung
- 40: zweite Heizeinrichtung
- 42: dritte Heizeinrichtung
- 44: weitere Heizeinrichtung
- 46: Lüftereinrichtung

## Patentansprüche

1. Wiederaufschmelzlötanlage (10) zum Durchführen eines Lötprozesses für zumindest ein Bauteil (26, 28, 30), mit zumindest einem ersten Transportband (18) zum Transportieren des Bauteils (26, 28, 30) durch die Wideraufschmelzlötanlage (10) während des Lötprozesses, und mit einer elektronischen Recheneinrichtung (12) zum Steuern des ersten Transportbandes (18), **dadurch gekennzeichnet, dass**
die Wiederaufschmelzlötanlage (10) zumindest ein zweites Transportband (20) aufweist, welches in einer Transportrichtung (32) der Wiederaufschmelzlötanlage (10) für das Bauteil (26, 28, 30) an das erste Transportband (18) angegliedert ist, wobei die elektronische Recheneinrichtung (12) dazu ausgebildet ist, unabhängig vom ersten Transportband (18) das zweite Transportband (20) zu steuern.

2. Wiederaufschmelzlötanlage (10) nach Anspruch 1, **dadurch gekennzeichnet, dass**
die elektronische Recheneinrichtung (12) zum Einstellen unterschiedlicher Transportgeschwindigkeiten der zumindest zwei Transportbänder (18, 20, 22, 24) ausgebildet ist.

3. Wiederaufschmelzlötanlage (10) nach Anspruch 1 oder 2, **dadurch gekennzeichnet, dass** zumindest das erste Transportband (18) und/oder das zweite Transportband (20) eine seitliche Begrenzung (34) für das Bauteil (26, 28, 30) aufweisen, wobei die seitliche Begrenzung (34) für eine Einstellung einer Breite variabel verschiebbar ist.

4. Wiederaufschmelzlötanlage (10) nach einem der vorhergehenden Ansprüche, **dadurch gekennzeichnet, dass**
einem jeweiligen Transportband (26, 28, 30) eine jeweilige Heizeinrichtung (38, 40, 42, 44) zugeordnet ist.

5. Wiederaufschmelzlötanlage (10) nach Anspruch 4, **dadurch gekennzeichnet, dass**
die elektronische Recheneinrichtung (12) dazu ausgebildet ist, die jeweiligen Heizeinrichtungen (38, 40, 42, 44) unabhängig voneinander zu steuern.

6. Wiederaufschmelzlötanlage (10) nach Anspruch 4 oder 5, **dadurch gekennzeichnet, dass**
die Heizeinrichtungen (38, 40, 42, 44) als Lüftereinrichtungen (46) ausgebildet sind.

7. Wiederaufschmelzlötanlage (10) nach einem der Ansprüche 4 bis 6, **dadurch gekennzeichnet, dass**
eine jeweilige Heizeinrichtung (38, 40, 42, 44) zumindest zwei Lüftereinrichtungen (46) aufweist.

8. Wiederaufschmelzlötanlage (10) nach einem der Ansprüche 4 bis 7, **dadurch gekennzeichnet, dass**
die elektronische Recheneinrichtung (12) dazu ausgebildet ist eine Temperatur der jeweiligen Heizeinrichtung (38, 40, 42, 44) und/oder eine Drehgeschwindigkeit der jeweiligen Heizeinrichtung (38, 40, 42, 44) zu steuern.

9. Wiederaufschmelzlötanlage (10) nach einem der vorhergehenden Ansprüche, **dadurch gekennzeichnet, dass**
die Wiederaufschmelzlötanlage (10) zumindest ein drittes Transportband (22) aufweist, welches an das zweite Transportband (20) angegliedert ist, wobei die elektronische Recheneinrichtung (12) dazu ausgebildet ist, das dritte Transportband (22) unabhängig vom ersten Transportband (18) und vom zweiten Transportband (20) zu steuern.

10. Wiederaufschmelzlötanlage (10) nach Anspruch 9, **dadurch gekennzeichnet, dass** dem dritten Transportband (22) eine dritte Heizeinrichtung (42) zugeordnet ist.

11. Wiederaufschmelzlötanlage (10) nach Anspruch 10, **dadurch gekennzeichnet, dass**
die elektronische Recheneinrichtung (12) dazu ausgebildet ist, unabhängig von einer ersten Heizeinrichtung (38) für das erste Transportband (18) und einer zweiten Heizeinrichtung (40) für das zweite Transportband (20) die dritte Heizeinrichtung (42) zu steuern.

12. Wiederaufschmelzlötanlage (10) nach einem der vorhergehenden Ansprüche, **dadurch gekennzeichnet, dass**
die Wiederaufschmelzlötanlage (10) eine erste Transportspur (14) mit zumindest dem ersten Transportband (18) und dem zweiten Transportband (20) aufweist und eine zweite Transportspur (16) mit zumindest einem weiteren Transportband (24) aufweist.

13. Verfahren zum Betreiben einer Wiederaufschmelzlötanlage (10) nach einem der Ansprüche 1 bis 12, mit den Schritten:
- Transportieren des zumindest einen Bauteils (26, 28, 30) mittels des ersten Transportbands (18);
- Übergeben des Bauteils (26, 28, 30) von dem ersten Transportband (18) zu dem zweiten Transportband (20);
- Transportieren des zumindest einen Bauteils (26, 28, 30) mittels des zweiten Transportbands (20); und
- Separates Steuern des ersten Transportbandes (18) und des zweiten Transportbandes (20) mittels der elektronischen Recheneinrichtung (12).

14. Verfahren nach Anspruch 13, **dadurch gekennzeichnet, dass**
das erste Transportband (18) mit einer unterschiedlichen Geschwindigkeit betrieben wird als das zweite Transportband (20).

15. Verfahren nach einem der Ansprüche 13 oder 14, **dadurch gekennzeichnet, dass**
eine erste Heizeinrichtung (38), welche dem ersten Transportband (18) zugeordnet ist, unterschiedlich betrieben wird als eine zweite Heizeinrichtung (40), welche dem zweiten Transportband (20) zugeordnet ist.
